# EUROPÄISCHE PATENTANMELDUNG

(11) **EP 1 037 254 A2**
(43) Veröffentlichungstag der Anmeldung: **20.09.2000**
(21) Anmeldenummer: 00104863.6
(22) Anmeldetag: 07.03.2000
(51) Int. Cl.: H01J 37/30, H01J 37/317

(54) **Einrichtung zur Ionenimplantation mit niedrigen Energien**

(30) Priorität: 17.03.1999 DE 19911900
(71) Anmelder: Forschungszentrum Rossendorf e.V., 01474 Schönfeld-Weissig (DE)
(72) Erfinder: Teichert, Jochen, Dr., 01239 Dresden (DE)

(57) **Zusammenfassung**

Der Erfindung liegt die Aufgabe zugrunde, eine Einrichtung vorzuschlagen, mit der ein Ionenstrahl mittlerer Energie für eine Niederenergie-Ionenimplantation einsetzbar ist. Dabei soll der Ionenstrahl so abgebremst werden, daß er mit Niederenergie auf das Target trifft und dort über die Targetfläche eine weitgehend konstante Ionendosis einbringt. Die Erfindung verwendet eine elektrostatische Bremslinse aus mindestens zwei Elektroden und eine weitere elektrostatische Linse, die in Strahlrichtung vor der Bremslinse angeordnet ist. Dabei entspricht der Abbildungsfehler der weiteren elektrostatischen Linse dem Betrag der Bremslinse, weist jedoch das entgegengesetzte Vorzeichen auf. Die weitere elektrostatische Linse kann als Sammellinse ausgebildet sein oder aus mindestens zwei Elektroden bestehen, von denen eine als Steuerelektrode ausgeführt ist.

## Beschreibung

Die Erfindung betrifft eine Einrichtung zur Ionenimplantation mit niedrigen Energien, wobei ein Ionenstrahl mittlerer Energie eingesetzt werden soll.

Die Ionenimplantation ist das bevorzugte Verfahren zur Dotierung von Halbleitern in der industriellen Massenproduktion von integrierten elektronischen Bauelementen. Die entscheidenden Parameter für einen Implantationsschritt mit einem vorgegebenen Dotieratom sind die Ionendosis und die Ionenenergie. Die Ionendosis bestimmt die Konzentration der eingebrachten Ionen in dem Halbleitermaterial. Die Ionenenergie ist wichtig im Bezug auf die Eindringtiefe der Ionen in das bestrahlte Material. Je höher die Energie und je kleiner die Masse der Ionen ist, um so höher ist die Eindringtiefe. Bei der Implantation von Dotanden in Halbleitermaterial wird die Ionenenergie verwendet um die Tiefe des pn-Übergangs zu steuern. Prozeßschritte mit hoher Ionenenergie, z.B. zur Erzeugung retrograder Wannen, erfordern Energien von einigen MeV (Hochenergieimplantation). Die meisten Implantationsschritte werden mit Ionen der Energie zwischen einigen zehn und hundert keV (Mittelenergieimplantation) durchgeführt. Für ultraflache pn-Übergänge werden Ionenenergien von wenigen keV oder sogar unter 1 keV benötigt (Niederenergieimplantation).
Der anhaltende Trend zu immer kleineren Halbleiterbauelementen verlangt zunehmend die Ionenimplantation mit kleinen Energien, so daß immer mehr Anlagen zur Ionenimplantation mit niedrigen Energien zur Produktion in der Halbleiterindustrie eingesetzt werden. Begleitet wird der zunehmende industrielle Einsatz mit wachsendem Interesse und Umfang der Forschungs- und Entwicklungsarbeiten auf dem Gebiet der Niederenergieimplantation. Vielfach sind Mittelenergie-Implantationsanlagen vorhanden, die aber so für die Niederenergieimplantation nicht geeignet sind. Die Anschaffung von Niederenergie-Implantationsanlagen ist wegen der hohen Kosten und der sehr speziellen Einsatzmöglichkeit oft keine vertretbare Lösung.

Eine bekannte Alternative stellt die Veränderung von Mittelenergie-Implantationsanlagen dar. So ist es bekannt, das Target elektrisch isoliert anzubringen und eine Hochspannung anzulegen (F. Hinterberger, Physik der Teilchenbeschleuniger und Ionenoptik, Springer-Verlag, Berlin 1997, S.197 ff). Damit lassen sich die Ionen vor dem Target abbremsen. Ihre Energie, die sie beim Auftreffen auf das Target besitzen, ist die Differenz zwischen Targetpotential und Beschleunigungsspannung im Strahlrohr der Implantationsanlage. Wird die Targetspannung ausreichend hoch gewählt, kann eine Niederenergieimplantation erfolgen, wobei die genutzte Mittelenergie-Implantationsanlage ausreichend oberhalb ihrer minimalen Energie betrieben wird.
Verbesserte Lösungen verwenden eine Bremslinse, wobei zusätzlich eine oder mehrere Elektroden vor dem auf Hochspannungspotential liegenden Target angeordnet sind (Gwilliam u.a., Proc. XII Int. Conf. on Ion Implantation Techn., Kyoto, June 22-26 1998).
Das "Hochlegen" des Targets und die Verwendung einer Bremslinse besitzen jedoch mehrere Nachteile. Für den industriellen Einsatz ist nachteilig, daß infolge der Hochspannung die Probenkammer aufwendiger ist und der Wechsel der Halbleiterscheiben komplizierter ist und mehr Zeit in Anspruch nimmt. Ein zweiter Nachteil ist jedoch bedeutsamer. Auf der Halbleiterscheibe erfolgt eine Ionenimplantation mit einer von Ort zu Ort unterschiedlichen Dosis. Es ist jedoch für Forschungsarbeiten ebenso wie für die Qualität der produzierten Halbleiterbauelemente wichtig, daß die Implantationsdosis auf der gesamten Halbleiterscheibe weitgehend gleiche Werte aufweist. Der Effekt wächst mit abnehmender Ionenenergie. Die stärkere Abbremsung vergrößert die Dosisinhomogenität, die jedoch bei flachen Implantationen besonders wesentlich ist.

Der Erfindung liegt die Aufgabe zugrunde, eine Einrichtung vorzuschlagen, mit der ein Ionenstrahl mittlerer Energie für eine Niederenergie-Ionenimplantation einsetzbar ist. Dabei soll der Ionenstrahl so abgebremst werden, daß er mit Niederenergie auf das Target trifft und dort über die Targetfläche eine weitgehend konstante Ionendosis einbringt.

Erfindungsgemäß wird die Aufgabe durch die in den Patentansprüchen angeführten Merkmale gelöst.

Der wesentliche Vorteil der Erfindung gegenüber den bisher bekannten Lösungen besteht darin, daß in der vorgeschlagenen Einrichtung die Linsenfehler korrigiert werden. Daraus ergibt sich, daß ein Target, insbesondere eine Halbleiterscheibe gegenwärtig üblicher Größe, auf seiner gesamten Fläche mit konstanter Ionendosis bestrahlt werden kann, und daß diese Implantation mit flächenmäßig konstanter Ionendosis für eine beliebig eingestellte Abbremsenergie gewährleistet wird. Gegenüber den bekannten Lösungen erweitert die vorgeschlagene Lösung den nutzbaren Energiebereich hin zu kleineren Energien und ermöglicht es gegebenenfalls einen Ionenstrahl höherer Energie der Implantationsanlage zu verwenden, für den der Ionenstrom größer ist. Dadurch kann die Implantationszeit verringert werden.

Die Erfindung wird nachstehend an einem Ausführungsbeispiel näher erläutert.
Die zugehörige Zeichnung zeigt die Prinzipdarstellung der Erfindung im Schnitt.
Das Ausführungsbeispiel umfaßt ein Einrichtung aus zwei elektrostatischen Linsen, die aus insgesamt vier Elektroden bestehen und in einer evakuierten Probenkammer 1 angeordnet sind. Der Ionenstrahl gelangt durch das Strahlrohr 2 in die Probenkammer 1. Im Strahlrohr 2 befinden sich ein Plattenpaar 3 zur vertikalen und ein Plattenpaar 4 zur horizontalen Ablenkung des Ionenstrahls, welche die Abrasterung der Probe mit dem Ionenstrahl ermöglichen. Vor dem elektrostatischen Linsensystem sind Faradaybecher 5 zur Ionendosismessung und eine Strahlblende 6 angeordnet. Die aufgeführten Baugruppen 2 bis 6 sind in der ursprünglichen Ausführung einer Mittelenergie-Implantationsanlage vorhanden und können weiter verwendet werden. Eine erste Linse, im weiteren als Fokussierlinse bezeichnet, besteht aus der Masseelektrode 7, der Fokussierelektrode 8 und der Steuerelektrode 9. Die Steuerelektrode 9 wird gleichzeitig als erste Elektrode einer zweiten Linse verwendet, die im folgenden als Bremslinse bezeichnet wird. Die Bremslinse besteht aus zwei Elektroden. Die zweite Elektrode ist die Bremselektrode 10, in welche der Targethalter 11 mit Probe integriert ist. Der Probenwechsel erfolgt durch eine Tür. An Bremselektrode 10, Targethalter 11 mit Target wird die Bremsspannung 12 angelegt. Im Zusammenspiel mit der Energie, mit der die Ionen in die Probenkammer gelangen, bestimmt die Bremsspannung die Implantationsenergie. Die Fokussierelektrode 8 befindet sich gleichfalls auf dem Potential der Bremsspannung 12, während für die Steuerelektrode eine zusätzliche Hochspannung 13, auch Steuerspannung 13 genannt, verwendet wird.

Im dargestellten Ausführungsbeispiel ist die Fokussierlinse eine Sammellinse mit negativen Abbildungsfehler und die Bremslinse eine Zerstreuungslinse mit positiven Abbildungsfehler. Die Größe des Abbildungsfehler der Zerstreuungslinse hängt von der Bremsspannung 12 und der Steuerspannung 13 ab. Der Abbildungsfehler der Fokussierlinse kann mit Hilfe der Steuerspannung 13 eingestellt werden. Die Abbildungsfehlerkorrektur erfolgt derart, daß bei Vorgabe der Bremsspannung 12, die Steuerspannung 13 so gewählt wird, daß die Abbildungsfehler der beiden Linsen vom Betrag her gleich groß sind und sich kompensieren. Damit wird die Implantation mit konstanter Dosis auf der gesamten Targetfläche gewährleistet. Da die Steuerspannung 13 jeweils der aktuellen Bremsspannung 12 angepaßt wird, kann die Abbildungsfehlerkorrektur für beliebig eingestellte Bremsspannungen 12 erfolgen. Die Auswahl der richtigen Steuerspannung 13 erfolgt anhand von Ergebnissen ionenoptischer Berechnungen. Das dargestellte Ausführungsbeispiel läßt sich in folgender Weise modifizieren:
- An die Fokussierelektrode 8 wird statt der Bremsspannung 12 eine unabhängige dritte Spannungsquelle angeschlossen.
- Anstatt der Werte aus ionenoptischen Berechnungen wird die Steuerspannung 13 in Abhängigkeit von der Bremsspannung 12 nach empirisch ermittelten Werten eingestellt.
- Im Unterschied zu dargestellten Ausführungsbeispiel ist der Targethalter 11 durch ein Rad ersetzt auf dem sich mehrere Probenhalterungen mit Proben befinden. Das Rad ist elektrisch isoliert angebracht und befindet sich auf dem gleichen elektrischen Potential wie die Bremselektrode 10. Die Probenhalterungen sind so ausgebildet, daß im Zusammenspiel mit der Bremselektrode 10 die elektrische Feldverteilung durch das Rad nicht gestört wird. Die Verwendung des Rades gestattet es, mehrere Proben zu implantieren, bevor eine Belüftung der Probenkammer und ein Probenwechsel durch die Tür erfolgen muß.

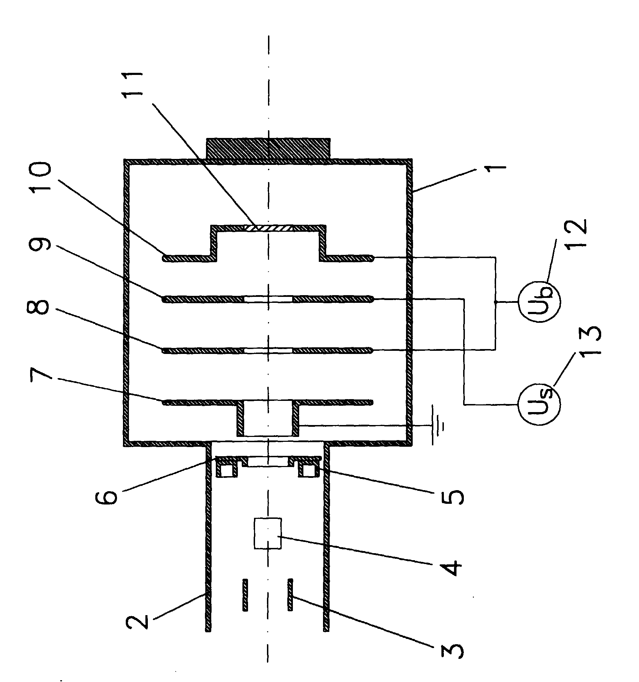

## Patentansprüche

1. Einrichtung zur Ionenimplantation mit niedrigen Energien unter Verwendung eines Ionenstrahls mittlerer Energie, einer Strahlblende, eines isolierten und auf Hochspannung gelegten Targets sowie einer elektrostatischen Bremslinse aus mindestens zwei Elektroden und einer weiteren elektrostatischen Linse, die in Strahlrichtung vor der Bremslinse angeordnet ist, dadurch gekennzeichnet, daß der Abbildungsfehler der weiteren elektrostatischen Linse dem Betrag der Bremslinse entspricht, jedoch das entgegengesetzte Vorzeichen aufweist.

2. Einrichtung nach Anspruch 1, dadurch gekennzeichnet, daß die weitere elektrostatische Linse eine Sammellinse ist.

3. Einrichtung nach Anspruch 1, dadurch gekennzeichnet, daß die weitere elektrostatische Linse aus mindestens zwei Elektroden (8;9) gebildet ist.

4. Einrichtung nach Anspruch 3, dadurch gekennzeichnet, daß eine Elektrode als Steuerelektrode (9) ausgeführt ist.

5. Einrichtung nach Anspruch 4, dadurch gekennzeichnet, daß die Steuerelektrode (9) mit einer einstellbaren Hochspannungsquelle (13) verbunden ist.

6. Einrichtung nach Anspruch 5, dadurch gekennzeichnet, daß die an der Steuerelektrode (9) anliegende Spannung in Abhängigkeit von der Bremsspannung (12) nach Werten ionenoptischer Berechnungen so einstellbar ist, daß die Kompensation der Linsenfehler erfolgt.

7. Einrichtung nach Anspruch 5, dadurch gekennzeichnet, daß die an der Steuerelektrode (9) anliegende Spannung in Abhängigkeit von der Bremsspannung (12) nach empirisch ermittelten Werten so einstellbar ist, daß die Kompensation der Linsenfehler erfolgt.
